# EUROPEAN PATENT APPLICATION

(11) **EP 2 474 401 A2**
(43) Date of publication of application: **11.07.2012**
(21) Application number: 12150560.6
(22) Date of filing: 10.01.2012
(51) Int. Cl.: B29C 33/68, B29C 45/02, B29C 45/16, B29C 45/18, H01L 21/56

(54) **Method of resin molding and resin molding apparatus**

(30) Priority: 11.01.2011 JP 2011002992
(71) Applicant: Apic Yamada Corporation, Chikuma-shi Nagano 389-0898 (JP)
(72) Inventor: Ikeda, Masanobu, Nagano, 389-0898 (JP); Morimura, Masahiro, Nagano, 389-0898 (JP); Nakayama, Hideo, Nagano, 389-0898 (JP); Sato, Hisashi, Nagano, 389-0898 (JP)
(74) Representative: Stuart, Ian Alexander

(57) **Abstract**

The resin molding method comprises the steps of: feeding a first resin (15, 15a) to a cavity concave portion (11a, 18a) of a molding die set (1), which is opened, and a second resin (16, 16a) to a pot (9) thereof; closing the molding die set (1) so as to clamp the work (W); and pressurizing and sending the molten second resin (16, 16a), which has been molten in the pot (9), to the cavity concave portion (11a, 18a), by a manner of transfer-molding, so as to mix the molten first resin (15, 15a), which has been molten in the cavity concave portion (11a, 18a), and the molten second resin (16, 16a) and cure the mixed resin with maintaining a prescribed resin pressure.

## Description

### FIELD OF THE INVENTION

The present invention relates to a method of resin molding, a resin molding apparatus and a feeding handler of the resin molding apparatus.

### BACKGROUND OF THE INVENTION

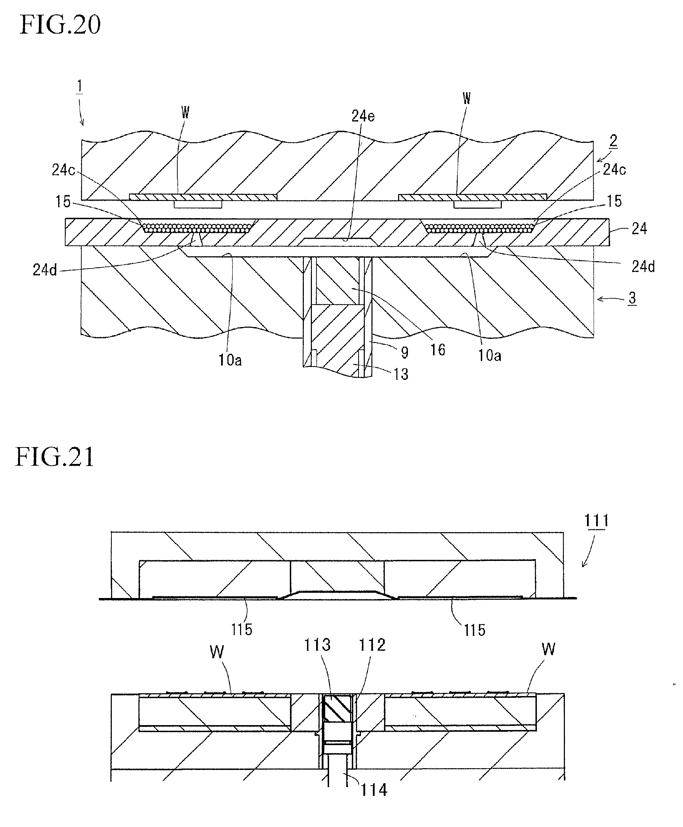

Transfer molding apparatuses have been used to produce thin packages, in which semiconductor chips are resin-molded. An example of conventional transfer molding apparatuses is shown in Fig. 21. In the drawing, works W are set in a molding die set 111 which has been opened, a resin tablet 113 is set in a pot 112 and the works W are clamped by the molding die set 111. Then, the resin, which is molten in the pot 112 by heat of a molding die, is pressurized and sent, by actuating a plunger 114, to cavities 115 via cull sections and gates of the molding die. The resin is thermally cured so as to mold semiconductor chips in packages.

These days, semiconductor chips have been downsized and highly integrated, so SiPs (System in Package), in each of which pluralities of semiconductor chips or electric parts are molded in one package, and POPs (Package On Package), in each of which semiconductor chips are multilayered, are required. The packages are made thinner, so it is difficult for molten resin to flow into small gaps between semiconductor chips and bottom parts of cavities. So, it is difficult to perfectly resin-mold semiconductor chips.

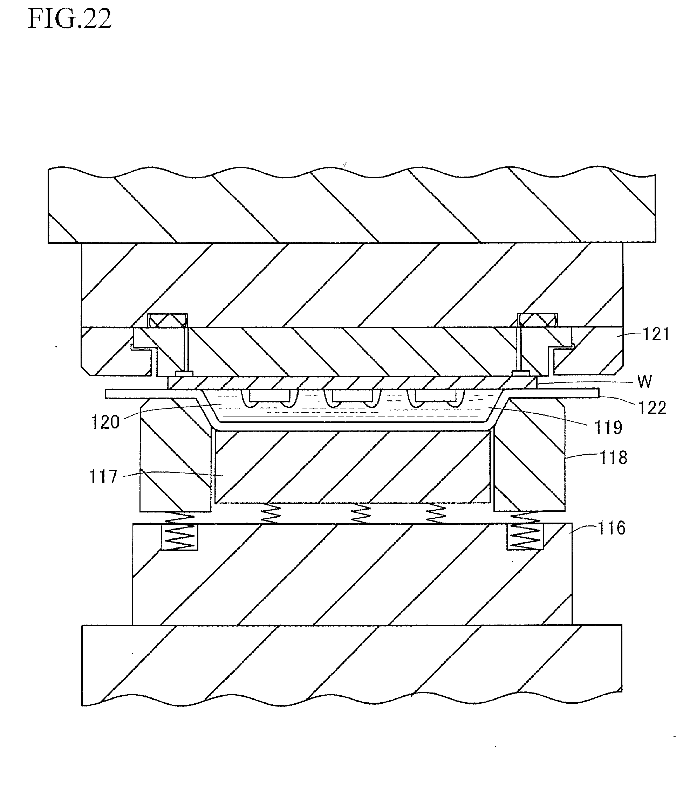

To solve the above described problem, compression molding apparatuses are used. An example of the compression molding apparatuses is shown in Fig. 22. A resin 120 (e.g., solid resin, granular resin, liquid resin) for molding is set and previously molten in a lower cavity concave portion 119, which is constituted by a lower cavity piece 117 floating-supported by a lower base 116 and a movable clamper 118 separately floating-supported from the lower cavity piece 117, and a work W is clamped by a molding die set and compression-molded with the molten resin 120 in a state where the work W is sucked and held on a clamping face of an upper insert 121. With this structure, the resin 120 can fill a small gap, whose width in the height direction of a package is narrow. Note that, a clamping face of a lower die including a lower cavity 119 is covered with a release film 122.

In the compression molding apparatus, if an amount of the resin fed to the cavity is not precisely controlled, thicknesses of packages will be varied. Thus, a transfer compression molding (TCM) apparatus, which has the effect of applying resin pressure obtained by the conventional transfer molding apparatus and the effect of perfect resin filling obtained by the conventional compression molding apparatus, has been invented (see Japanese Laid-open Patent Publication No. P2009-190400A). In the TCM apparatus, a resin is transferred to a cavity concave portion, and then compression molding is performed by moving a movable cavity piece in the cavity concave portion.

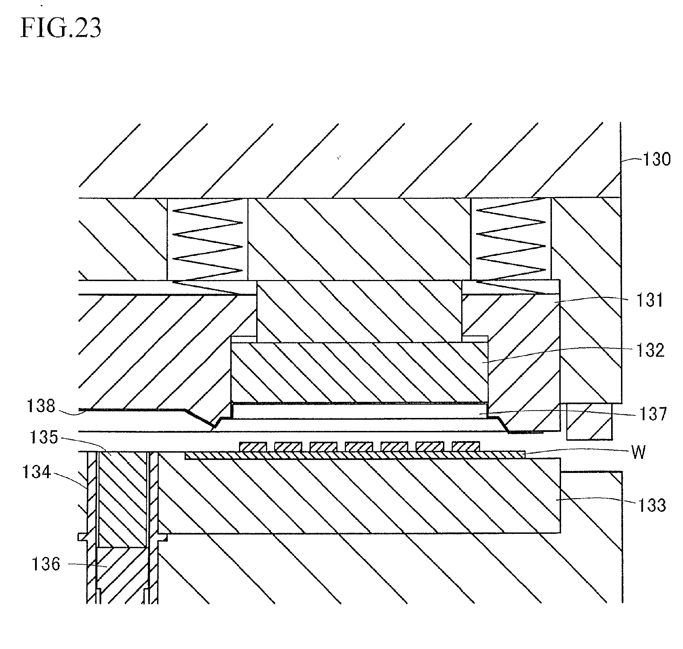

An example of the TCM apparatus is shown in Fig. 23. An upper mold chase 131 is suspended from an upper base 130, and an upper cavity piece 132 constitutes a ceiling part of an upper cavity concave portion 137. A work W is mounted on a lower insert 133, and a resin tablet 135 is set in a pot 134. In a state where a molding die set is closed and the work W is clamped by the upper mold chase 131, a relative position of the upper cavity piece 132, with respect to the upper mold chase 131, is not varied. In this state, a plunger 136 is actuated to pressurize and send the molten resin 135 in the pot 134 to the upper cavity concave portion 137. With this action, the upper cavity concave portion 137 is filled with the molten resin 135. By further closing the molding die set, the upper cavity piece 132 is relatively moved downward, with respect to the upper mold chase 131, until the ceiling part of the upper cavity concave portion 137 reaches a predetermined position so as to resin-molding a package with a designed thickness, and then the resin is thermally cured. In this action, surplus resin reversely flows, in a runner, and pushes the plunger 136 downward. Therefore, the resin can fill the cavity concave portion 137 and the resin pressure can be maintained. Note that, a clamping face of an upper die, including the upper cavity concave portion 137, is covered with a release film 138.

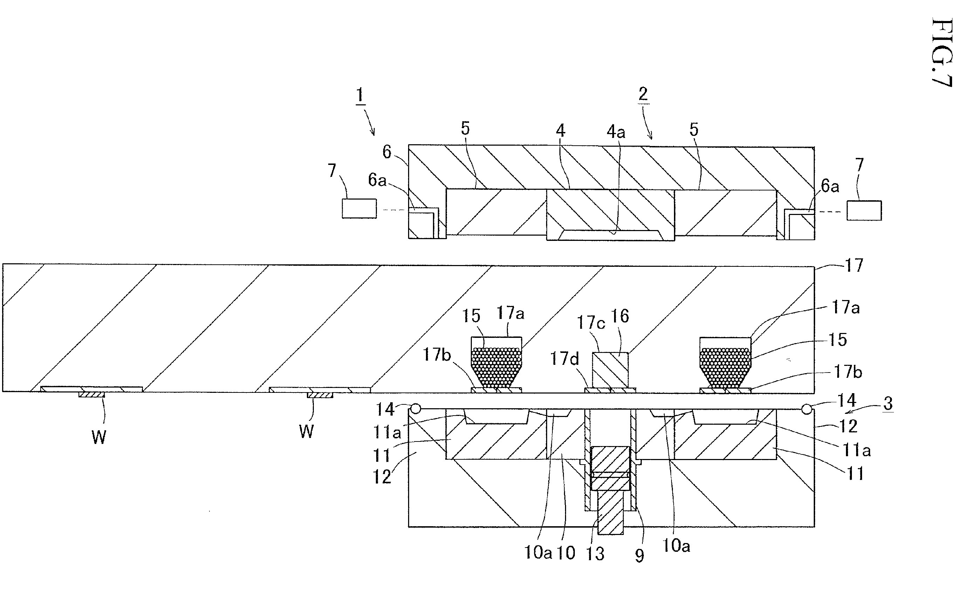

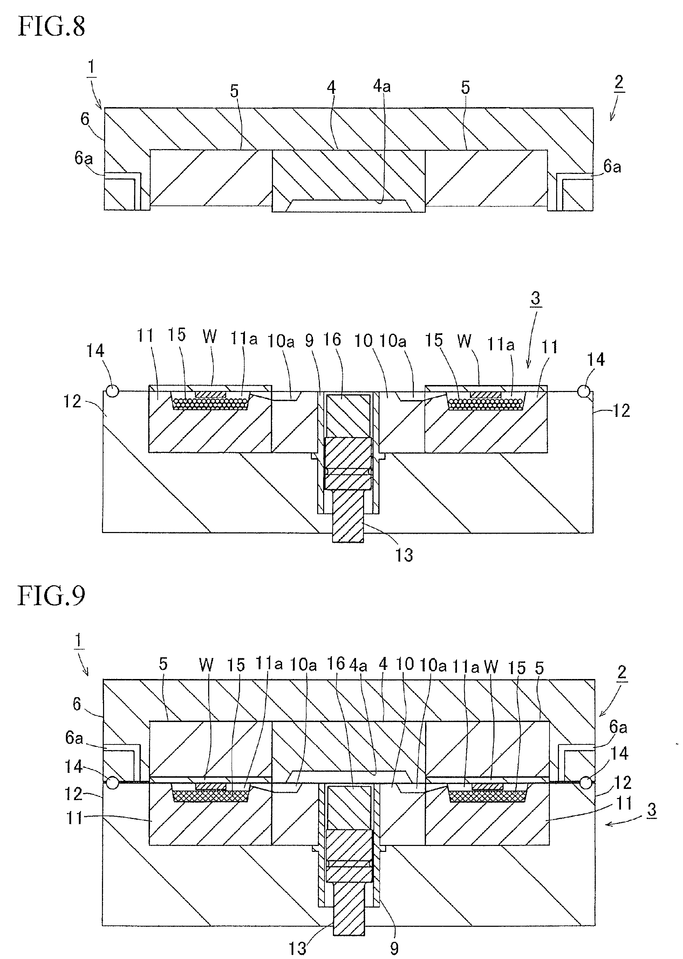

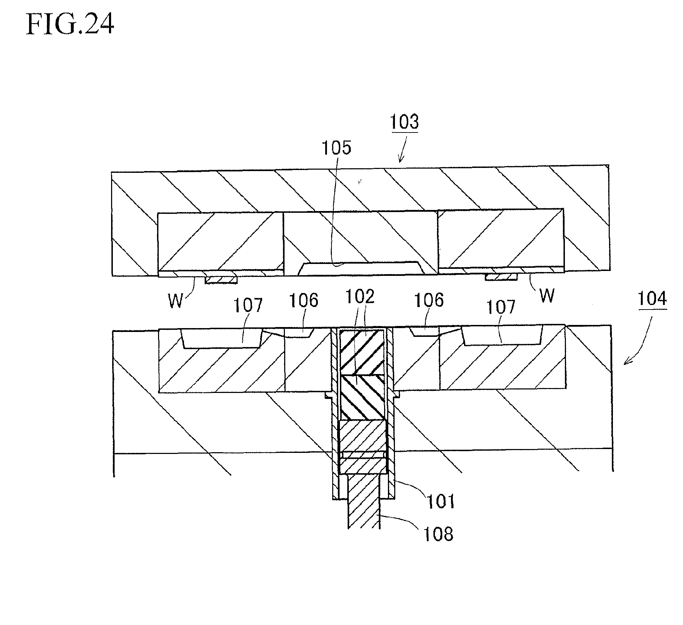

For example, in case of molding a large work, (e.g., in-car ECU, FBGM, MAP, IGBT) with a large amount of resin, pluralities of resin tablets are stacked in a pot as shown in Fig. 24. In the drawing, two or three resin tablets 102 are stacked in a pot 101, works W are sucked and held by an upper die 103. The works W are clamped by the upper die 103 and a lower die 104, and the molten resin is pressurized and sent, by actuating a plunger 108, to cavity concave portions 107 via an upper cull section 105 and lower runner gates 106 (see Japanese Laid-open Patent Publication No. P2010-165748A and Figs. 7 and 8 thereof). Note that, in Japanese Laid-open Patent Publication No. P2010-165748A, when electronic parts, which are non-uniformly arranged on a substrate, are resin-molded, two types of the resins, whose cure-and-contractive characteristics are different (e.g., a difference in grass-transition temperature is 5°C or more), are stacked in the pot so as to reduce a difference between contractive forces of the resins. The stacked resins are molten, pressurized and sent so as to fill the cavity concave portions.

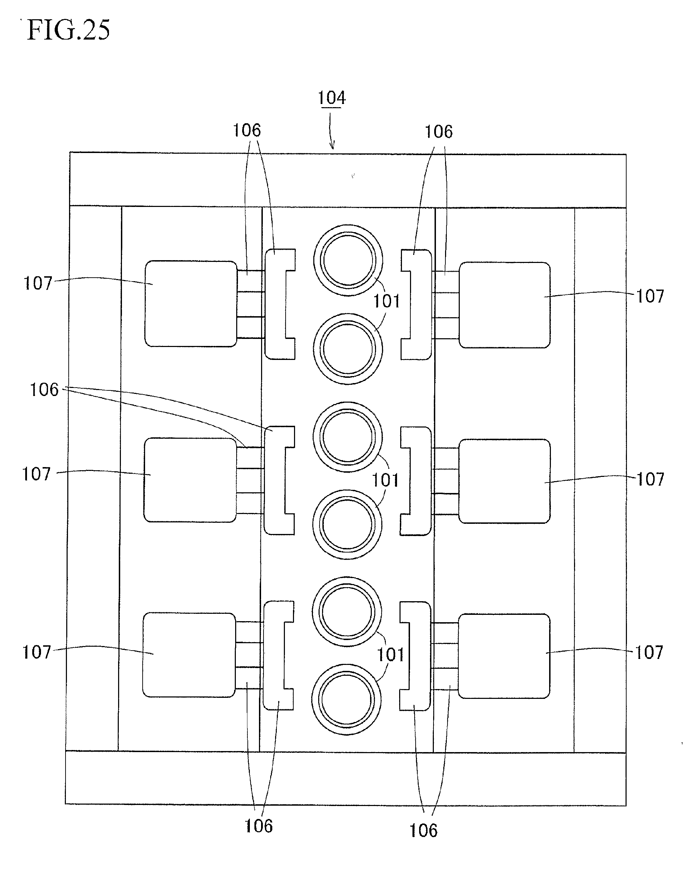

As shown in Fig. 25, pluralities of pots 101 may be formed in a lower die 104. A pressurized resin is sent to cavity concave portions 107 via common lower runner gates 106.

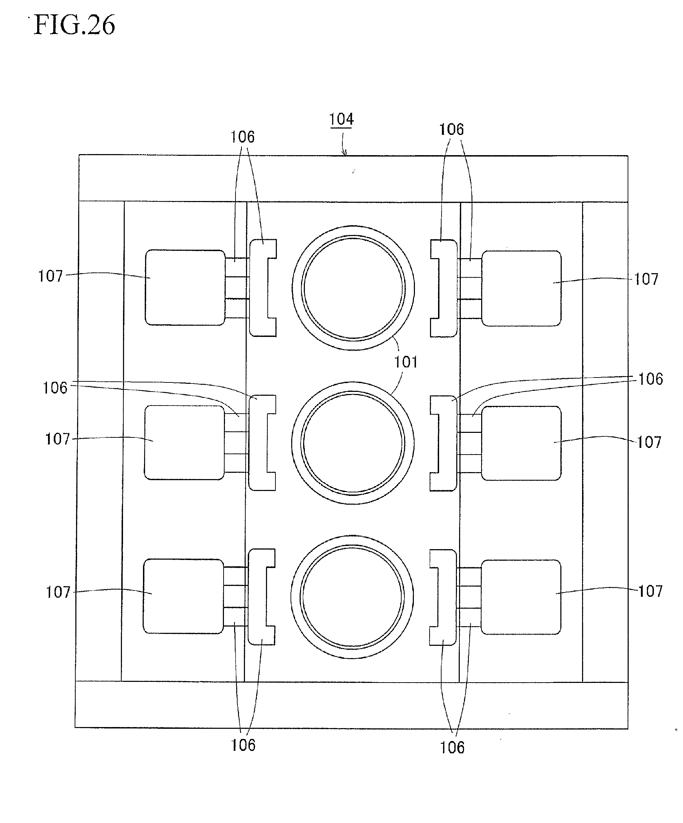

Further, as shown in Fig. 26, pluralities of large-diameter pots 101 are formed. A capacity of each of the pots 101 is a total capacity of corresponding cavity concave portions 107 plus α (e.g., capacities of a cull section and runner gates). In this case, a large resin tablet or tablets are set in the pots 101, molten and pressurized therein and sent to the cavity concave portions 107.

However, in case that the compression molding apparatus shown in Fig. 22 or the TCM apparatus shown in Fig. 23 is used to resin-mold thin packages, and movable members, e.g., the movable clamper constituting the cavity concave portion, are included, so the resin will invade into gaps between the movable members and fixed members. The resin invasion will cause operation failure. To solve this problem, the release film is used. However, by using the release film, a running cost of the molding apparatus must be increased. In case of resin-molding thin packages, a conventional inexpensive solid resin (e.g., tablet resin), whose melt time is long, will cause wire sweep. Further, an amount of the resin to be fed must be precisely controlled, so granular resin or liquid resin, which is relatively expensive, must be used, so production cost of molded products must be increased.

When the release film is sucked and held, the release film is extended along inner faces of the cavity concave portion. Even if the cavity concave portion is precisely formed, the release film is extended on sides and at corners of the cavity concave portion, so the thickness of the release film is varied. Further, the release film is deformed when the movable members are moved away from the release film. By the deformation, wrinkles will be easily formed in the release film. If wrinkles are formed, a shape of the package is different from that of the cavity, so the thin package cannot be precisely formed. The thin release film, whose thickness is about 50 µm, will be easily broken by, for example, edges of the dies. If the release film is broken, the dies must be cleaned.

In case of molding a large work with a large amount of resin, pluralities of the resin tablets 102 are stacked in the pot 101 as shown in Fig. 24. However, a stroke of the plunger 108 is structurally limited, so number of stacking the resin tablets 102 is also limited. A large amount of the resin flows and runners must be long, so the resin must be sent at relatively high pressure. By the high resin pressure, wire sweep, for example, will occur in the semiconductor chips bonded on a substrate (the work W), lead lines of capacitors will be bent or displaced.

In case of providing pluralities of the pots 101 as shown in Fig. 25, separations between the works W must be longer, so number of the works W molded in one molding action cannot be increased, so production efficiency must be lowered. Further, in case of using large-diameter resin tablets as shown in Fig. 26, it takes a long time to melt the resins in the pots 101, so production efficiency must be lowered.

Accordingly, it is an object to provide a resin molding method and a resin molding apparatus capable of solving the above described problems of the above described conventional resin molding apparatuses. Namely, the method and apparatus of the present invention is capable of mixing a molten first resin, which has been molten in a cavity concave portion, and a molten second resin, which has been molten in a pot, so as to reduce an amount of the resin flowing, reduce a load applied to a work, mold the work with maintaining a prescribed resin pressure and improve quality of a molded product. Another object is to provide a feeding handler capable of efficiently feeding the resins and the work.

To achieve the objects, the present invention has following structures.

Namely, the resin molding method of the present invention comprises the steps of:
feeding a first resin to a cavity concave portion of a molding die set, which is opened, and a second resin to a pot thereof;
feeding a work to a prescribed position of the molding die set , which corresponds to the cavity concave portion;
closing the molding die set so as to clamp the work; and
pressurizing and sending the molten second resin, which has been molten in the pot, to the cavity concave portion, by a manner of transfer-molding, so as to mix the molten first resin, which has been molten in the cavity concave portion, and the molten second resin and cure the mixed resin with maintaining a prescribed resin pressure.

With this method, by mixing the first resin and the second resin, an amount of the resin flowing in the cavity concave portion can be reduced, a load applied to the work can be reduced, and abrasion of molding dies, especially gates, can be restrained. By performing the transfer molding with maintaining the prescribed resin pressure in the cavity concave portion, the resins can perfectly fill the cavity concave portion. Even in case of resin-molding a large and thin work, quality of the molded product can be improved.

Concretely, the first resin is fed to the cavity concave portion of the molding die set and the second resin is fed to the pot thereof, the work is fed to the prescribed position of the molding die set, which corresponds to the cavity concave portion,
the molten second resin, which has been molten in the pot, is pressurized and sent, by actuating a plunger, toward the molten first resin, which has been molten in the cavity concave portion,
the molten first resin is mixed with the molten second resin, which has been pressurized and sent from the pot, and
the mixed resin is thermally cured with maintaining a prescribed resin pressure.

Note that, sectional shapes of the pot and the plunger are not limited to circular shapes. They may have, for example, square sectional shapes.

In the method, the first resin and the second resin may be powder resin, granular resin, liquid resin, tablet resin or combination thereof.

Therefore, types of the resins can be selected on the basis of a production cost, a quality of a molded product, etc., so the work can be molded with the suitable resins.

In the method, an inner space of the molding die set may be shielded from outside and a decompressed space may be produced in the inner space before completing a clamping action of the molding die set.

With this method, the resin molding is performed in the decompressed space, voids in the resins can be reduced and quality of the molded product can be improved.

In the method, an amount of the first resin to be fed may be a prescribed amount less than that for filling the cavity concave portion, and
an amount of the second resin to be fed may be equal to the prescribed amount so as to offset the shortage of the first resin.

In this method, when the second resin is pressurized and sent to the cavity concave portion to mix the first resin and the second resin after the molding die set is closed, a space is formed in the cavity concave portion so that air in runner gates of molding dies can be easily purged from air vents, which are formed side edges of the cavity concave portion.

The amount of the first resin to be fed need not be measured precisely, and the amount of shortage can be offset by the second resin. Therefore, the resin feeding action can be simplified.

In case that the amount of the first resin to be fed is a predetermined amount, with respect to the amount of resin for filling the cavity concave portion, the second resin fills a runner from the pot to the cavity concave portion with maintaining the prescribed resin pressure in the cavity concave portion, the mixed resin does not flow in the cavity concave portion and the resin molding can be performed with applying the resin pressure by the second resin. The first and second resins need not be the same resin. An inexpensive resin may be used as the resin for applying resin pressure.

In the method, the first resin may be introduced into an overflow cavity when the molten first resin and the molten second resin are mixed.

With this method, a small amount of the resin in a forward end part of the first resin, which has been fed into the cavity concave portion, is introduced into the overflow cavity when the pressurized second resin is mixed with the first resin in the cavity concave portion so that quality of a molded product can be improved.

In the method, a release film may be sucked and held on a clamping face of a molding die, which includes the cavity concave portion.

By using the release film, extension of the release film will badly influence quality of a molded product, but maintenance of the molding die set can be performed easily.

In the method, the first resin may be produced by crushing tablet resin, which is used as the second resin.

If a total amount of the first resin and the second resin to be fed is previously determined, the crushed inexpensive solid resin (tablet resin) can be used as the first resin too. The crushed resin can be easily molten in the cavity concave portion, and the first resin and the second resin can be stored in the same environment (e.g., thermal history, moisture absorption) so that the resins can be easily handled and quality of molded products can be stabilized.

The resin molding apparatus of the present invention comprises:
a molding die set, in which a first resin is fed to a cavity concave portion formed in a clamping face of a molding die, a second resin is fed to a pot and a work is fed to a prescribed position corresponding to the cavity concave portion; and
a transfer mechanism closing the molding die set so as to clamp the work, the transfer mechanism actuating a plunger so as to pressurize and send the molten second resin to the cavity concave portion and mix with the molten first resin, and
the transfer mechanism thermally cures the mixed resin in the cavity concave portion with maintaining a prescribed resin pressure.

With this structure, by mixing the first resin and the second resin, an amount of the resin flowing in the cavity concave portion can be reduced, a load applied to the work can be reduced, and abrasion of molding dies, especially gates, can be restrained. By performing the transfer molding with maintaining the prescribed resin pressure in the cavity concave portion, the resins can perfectly fill the cavity concave portion. Even in case of resin-molding a large and thin work, quality of the molded product can be improved.

In the resin molding apparatus, the first resin and the second resin may be powder resin, granular resin, liquid resin, tablet resin or combination thereof.

Therefore, a type of resin can be selected on the basis of a production cost, a quality of a molded product, etc., so the work can be molded with the suitable resins.

The resin molding apparatus may further comprise a decompressing mechanism for shielding an inner space of the molding die set from outside and producing a decompressed space in the inner space by purging air when the molding die set clamps the work.

With this structure, the resin molding is performed in the decompressed space, voids in the resins can be reduced and a quality of the molded product can be improved.

In the resin molding apparatus, an overflow cavity, which is communicated to the cavity concave portion, may be formed in the clamping face of the molding die, and
the first resin may be introduced into the overflow cavity when the molten first resin and the molten second resin are mixed.

With this structure, a small amount of the resin in a forward end part of the first resin, which has been fed into the cavity concave portion, is introduced into the overflow cavity when the pressurized second resin is mixed with the first resin in the cavity concave portion so that a quality of a molded product can be improved.

The resin molding apparatus may further comprise a resin crushing section crushing a tablet resin so as to use the crushed resin as the first resin and the second resin.

With this structure, if a total amount of the first resin and the second resin to be fed is previously determined, a crushed inexpensive solid resin (tablet resin) can be used as the first resin too. The crushed resin can be easily molten in the cavity concave portion, and the first resin and the second resin can be stored in the same environment (e.g., thermal history, moisture absorption) so that the resins can be easily handled and a quality of molded products can be stabilized.

In the resin molding apparatus, a release film may be sucked and held on the clamping face of the molding die, in which the cavity concave portion is formed.

By using the release film, extension of the release film will badly influence quality of a molded product. But, in case of molding the product including a thick package, an external shape is hardly influenced, so that maintenance of the molding die set can be performed easily.

A feeding handler of the present invention is moved into and away from the opened molding die set of the resin molding apparatus so as to feed a same type of resin or different types of resins to the pot and the cavity concave portion.

With this structure, the same type of resin or different types of resins can be simultaneously fed, to the pot and the cavity concave portion of the opened molding die set, by one reciprocating action of the feeding handler.

The feeding handler may feed not only the first resin and the second resin but also a work to a prescribed position corresponding to the cavity concave portion.

With this structure, the same type of resin or different types of resins and the work can be simultaneously fed, to the pot and the cavity concave portion of the opened molding die set, by one reciprocating action of the feeding handler. Therefore, the resins and the work can be efficiently fed to the molding die set.

In the resin molding method of the present invention, the molten first resin, which has been fed into the cavity concave portion, and the molten second resin, which has been fed into the pot, are mixed in the cavity concave portion, the amount of the mixed resin flowing in the cavity concave portion can be reduced. The load applied to, especially, a large work can be reduced, and abrasion of the molding dies, especially gates, can be reduced. By performing the transfer molding with maintaining the prescribed resin pressure in the cavity concave portion, the resins can perfectly fill the cavity concave portion. Even in case of resin-molding a large and thin work, a quality of the molded product can be improved. Even if the amount of the resins for molding the works is increased, the first resin is previously fed into the cavity concave portions, so the amount of the resin is not influence by capacity of the pot. Therefore, number of the cavity concave portions can be highly increased, so that a large number of the works can be molded.

By employing the resin molding apparatus and the feeding handler of the present invention, the resins and the work can be simultaneously fed by one reciprocating action of the feeding handler, so that the resins and the work can be efficiently fed.

### BRIEF DESCRIPTION OF THE DRAWINGS

Embodiments of the present invention will now be described by way of examples and with reference to the accompanying drawings, in which:
Fig. 1 is a sectional view of a resin molding apparatus of Embodiment 1, which shows a resin molding action;
Fig. 2 is a sectional view of the resin molding apparatus of Embodiment 1, which shows the resin molding action;
Fig. 3 is a sectional view of the resin molding apparatus of Embodiment 1, which shows the resin molding action;
Figs. 4A-4C are sectional views of the resin molding apparatus of Embodiment 1, which shows the resin molding action;
Fig. 5 is a table showing types of first resin fed to a cavity concave portion and second resin fed to a pot;
Figs. 6A and 6B are block diagrams of the resin molding apparatuses, which have different resin feeding systems;
Fig. 7 is a sectional view of another feeding handler;
Fig. 8 is a sectional view of a molding die set, in which the resins and works are fed;
Fig. 9 is a sectional view of the molding die set shown in Fig. 8, in which the works are clamped;
Fig. 10 is a plan view of a modified molding die set;
Fig. 11 is a sectional view of another modified molding die set;
Fig. 12 is a sectional view of a resin molding apparatus of Embodiment 2, which shows a resin molding action;
Figs. 13A and 13B are sectional views of the resin molding apparatus of Embodiment 2, which shows the resin molding action;
Fig. 14 is a sectional view of a resin molding apparatus of Embodiment 3, which shows a resin molding action;
Fig. 15 is a sectional view of a resin molding apparatus of Embodiment 4;
Fig. 16 is a sectional view of a resin molding apparatus of Embodiment 5;
Fig. 17 is a sectional view of a resin molding apparatus of Embodiment 6;
Fig. 18 is a sectional view of a resin molding apparatus of Embodiment 7;
Fig. 19 is a sectional view of a resin molding apparatus of Embodiment 8;
Fig. 20 is a sectional view of a resin molding apparatus of Embodiment 9;
Fig. 21 is a sectional view of the conventional transfer molding apparatus;
Fig. 22 is a sectional view of the conventional compression molding apparatus;
Fig. 23 is a sectional view of the conventional TCM apparatus;
Fig. 24 is a sectional view of the conventional molding die set for transfer molding;
Fig. 25 is a sectional view of another conventional molding die set for transfer molding; and
Fig. 26 is a sectional view of further conventional molding die set for transfer molding.

### DETAILED DESCRIPTION OF THE EMBODIMENTS

Preferred embodiments of the present invention will now be described in detail with reference to the accompanying drawings. The present invention is **characterized in that** a first resin fed into a cavity concave portion and a second resin fed into a pot are mixed, by a manner of transfer molding, and the mixed resin is thermally cured, in the cavity concave portion, with applying a prescribed resin pressure. Note that, the first resin and the second resin may be a same type of resin or different types of resins (e.g., granular resin, powder resin, liquid resin, tablet resin).

### (Embodiment 1)

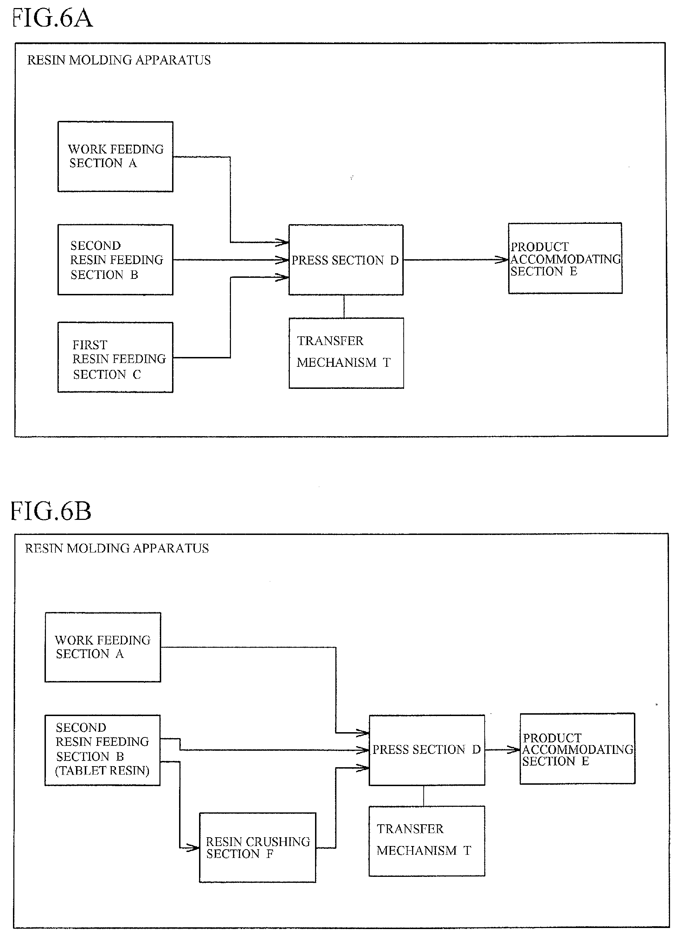

Firstly, a schematic structure of a resin molding apparatus of the present embodiment will be explained with reference to Fig. 6A. The resin molding apparatus comprises: a work feeding section A, which feeds works W to be resin-molded; a first resin feeding section C, which feeds first resins to cavity concave portions of a molding die set; a second resin feeding section B, which feeds second resins to pots; a press section D, which includes the molding die set; and a product accommodating section E, in which molded products are accommodated.

In the press section D, the first resins, e.g., granular resin, are fed into the cavity concave portions by a feeding handler (described later), and the second resins, e.g., tablet resin, are fed into the pots by the feeding handler. The works W are set at positions corresponding to the cavity concave portions of the molding die set.

The press section D includes a transfer mechanism T, which closes the molding die set so as to clamp the works W and which actuates plungers so as to pressurize and send the second resins molten in the pots to the cavity concave portions. By sending the second resins to the cavity concave portions, the first resins and the second resins are mixed therein.

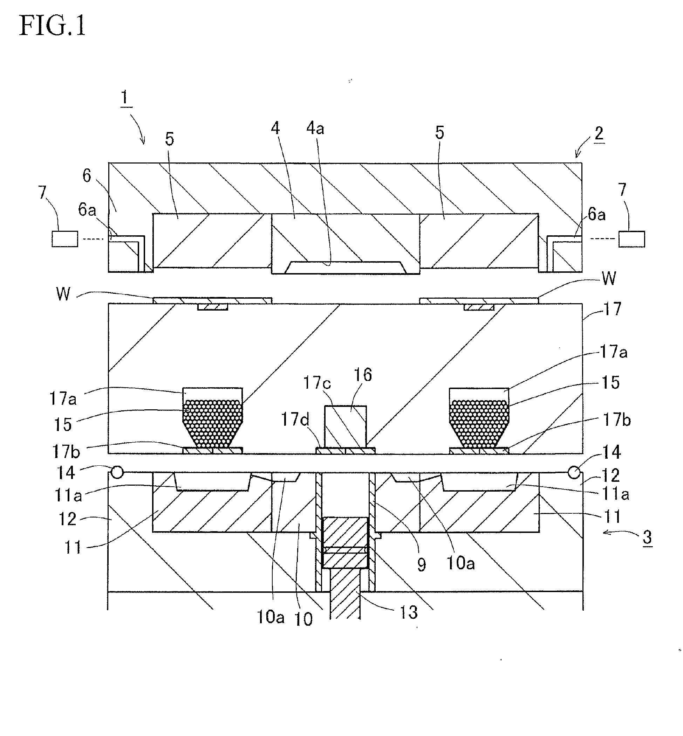

A schematic structure of the molding die set 1, which includes an upper die 2 and a lower die 3, will be explained with reference to Fig. 1. Note that, in the present embodiment, the upper die 2 is a fixed die, and the lower die 3 is a movable die. A clamping mechanism includes a driving source, e.g., electric motor, and a link unit, e.g., toggle link unit, which is driven by the driving source so as to move the movable die 3 in the vertical direction.

In the upper die 2, a cull insert 4, in which cull sections 4a are formed, upper die inserts 5, on each of which the work W is sucked and held, and an upper mold chase 6, which forms a closed space with a lower mold chase 12 of the lower die 3, are provided to an upper base (not shown). The works W are held on bottom faces of the upper die inserts 5, which are enclosed by the cull insert 4 and the upper mold chase 6. Air-sucking holes (not shown) for sucking and holding the works W are formed in the upper die inserts 5. Suction paths 6a are formed in the upper mold chase 6. The suction paths 6a are communicated to a decompression mechanism 7, which includes a vacuum pump for purging air from the closed space of the molding die set 1.

In the lower die 3, a pot insert 10, in which the pots 9 and runner gates 10a are formed, and cavity inserts 11, in which the cavity concave portions 11a are formed, are held by the lower mold chase 12. The lower mold chase 12 is supported by a lower base (not shown). Note that, the plungers 13 are respectively set in the pots 9 and moved upward and downward by the transfer mechanism T (see Fig. 6A). The plungers 13 are supported by a pressure equalization unit (not shown). The transfer mechanism T is attached to a movable platen (not shown), which is moved upward and downward by the clamping mechanism, and has the pressure equalization unit, which is vertically driven by a driving source separated from a driving source of the clamping mechanism. By driving the transfer mechanism T, the plungers 13 supported by the pressure equalization unit are moved upward, so that the second resins can be transferred.

Seal members 14 (e.g., O-ring) are fitted on a clamping face of the lower mold chase 12. When the decompression mechanism 7 is actuated and the molding die set 1 is closed, a clamping face of the upper mold chase 6 contacts the seal members 14, so that the inner space of the molding die set 1 is shielded from outside and a decompressed space can be produced therein.

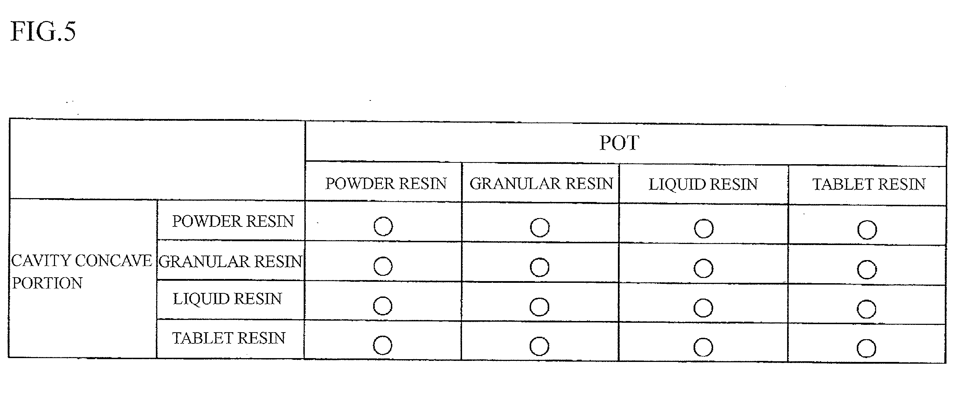

The first resin, which is fed to each of the cavity concave portions 11a and the second resin, which is fed to each of the pots 9, may be selected from powder resin, granular resin, liquid resin and tablet resin. Further, the first resin and the second resin may be a same resin or different resins. Combinations of the first resin and the second resin are shown in a table of Fig. 5. Therefore, the works can be molded with the resins suitable to production costs, quality of products, etc. Note that, characteristics of the first resin and the second resin may be the same or different.

In the present embodiment, the first resins 15, which are thermosetting resins (e.g., epoxy resin, silicone resin) and in which components (e.g., fillers (silica, alumina, etc.), release agent, coloring agent) are uniformly included, are respectively fed into the cavity concave portions 11a. Note that, the type and the components of the first resin 15 are not limited to this example. On the other hand, the second resins 16 (e.g., mini-tablet resin) are respectively fed into the pots 9. Note that, the type of the second resin 16 is not limited to this example. For example, in case that granular resin is used as the first resin 15, production processes of granular resin and mini-tablet resin (the second resin 16) are similar, so molded products having uniform resin characteristics can be produced.

The works W are, for example, plastic substrates on which semiconductor chips, capacitors, etc. are mounted. The types of the first resin 15 and the second resin 16 may be the same.

The works W, the first resins 15 (e.g., granular resin) and the second resin 16 (e.g., tablet resin) are fed into the molding die set 1, which has been opened, by the feeding handler 17.

For example, the works W, whose semiconductor chip mounting faces are facing downward, are mounted on an upper face of the feeding handler 17. Hoppers 17a, which store the first resins 15 (e.g., granular resin), are provided in the feeding handler 17. By opening shutters 17b from central parts, bottom parts of the hoppers 17a are opened, so that the first resin 15 (e.g., granular resin) can be fed into the cavity concave portions 11a. The first resin 15 (e.g., granular resin) of an amount for one resin molding, which corresponds to a capacity of each of the cavity concave portions 11a, may be stored in each of the hoppers 17a, or the first resin 15 may be fed, with measuring the required amount of the resin for one resin molding, by opening and closing the shutter 17b of each of the hoppers 17a.

Tablet holding sections 17c, which are capable of holding the second resins (tablet resins) 16, are provided in the feeding handler 17. Each of the tablet holding sections 17c is opened and closed by a shutter 17d.

In the feeding handler 17, the works W are located and held at the positions corresponding to work sucking sections of the upper die 2, the hoppers 17a are located at the positions corresponding to the cavity concave portions 11a of the lower die 3, and the tablet holding sections 17c are located at the positions corresponding to the pots 9. The works W are sucked and held, but the means for holding the works W is not limited to air suction. For example, the works W may be held by mechanical hands. Note that, the feeding handler 17 may feed the first and second resins 15 and 16 only. Further, the feeding handler 17 may feed the works W and the second resins 16 only. In this case, the first resins 15 may be fed by another handler. For example, in case of using liquid resin which gradually cures in tubes or a conveying unit, it is difficult to convey the liquid resin a long distance. To solve this problem, a resin feeding section is provided in the vicinity of the press section D, and the resin feeding section may be feeding means separated from the feeding handler 17.

As shown in Fig. 7, the feeding handler 17 may feed the works W to the prescribed positions of the molding die set 1 after feeding the first and second resins 15 and 16. In this case, the hoppers 17a in the feeding handler 17 are located at the positions corresponding to the cavity concave portions 11a of the lower die 3, and the tablet holding sections 17c of the feeding handler 17 are located at the positions corresponding to the pots 9. The feeding handler 17 is elongated in the moving direction, and resin feeding parts and work feeding parts in the feeding handler 17 are located at the positions corresponding to the cavity concave portions 11a. The works W are sucked and held by the work feeding parts of the feeding handler 17. The resin feeding parts of the feeding handler 17 is moved into the opened molding die set 1, and then the shutters 17b are opened, from the central parts, so as to open the bottom parts of the hoppers 17a, so that the first resins 15 (e.g., granular resin) can be fed into the cavity concave portions 11a. Then, the feeding handler 17 is further moved inward to make the work feeding parts correspond to the cavity concave portions 11a of the lower die 3. Note that, press members, which press the first resins 15 (e.g., granular resin) onto the cavity concave portions 11a so as to promote heating the first resins 15, and a heater for heating the first resin 15 (e.g., granular resin) may be provided to the feeding handler 17.

In Fig. 8, the feeding handler 17 is moved away from the molding die set 1, and the first resins 15 and the works W are set in the cavity concave portions 11a. From this state, the molding die set 1 is closed to clamp the works W, and the transfer mechanism T (see Fig. 6A) is actuated with producing the decompressed space in the molding die set 1.

Next, the resin molding method performed by the resin molding apparatus will be explained with reference to Figs. 1-4C. The resin molding method comprises the steps of: feeding the first and second resins 15 and 16 to the cavity concave portions 11a and the pots 9 of the opened molding die set 1; feeding the works W to the prescribed positions of the molding die set 1 corresponding to the cavity concave portions 11a; closing the molding die set 1 to clamp the works W; actuating the plungers 13 to pressurize and send the molten second resins 16 to the cavity concave portions 11a and mix the molten second resins 16 with the molten first resins 15; and pressure-curing the mixed resin.

The resin molding method of the present embodiment will be more precisely explained.

In Fig. 1, the first resins 15 (e.g., granular resin), the second resins 16 (e.g., tablet resin) and the works W are fed to the opened molding die set 1 by the feeding handler 17.

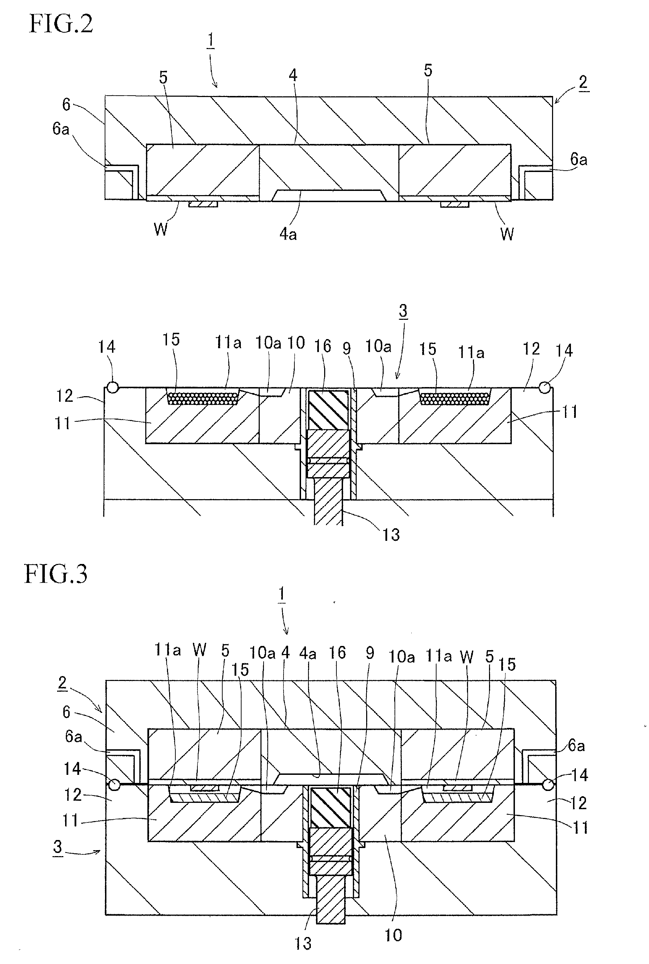

As shown in Fig. 2, the works W are sucked and held by work sucking parts (i.e., the bottom faces of the upper die inserts 5). The first resins 15 (e.g., granular resin) are fed into the cavity concave portions 11a from the hoppers 17a by opening the shutters 17b. The second resins 16 (e.g., tablet resin) are fed into the pots 9 from the tablet holding section 17c by opening the shutters 17d.

Next, the lower die 3 is moved upward, with actuating the decompression mechanism 7 connected to the upper die 2, so as to close the molding die set 1. From when the upper mold chase 6 contacts the seal members 14 of the lower mold chase 12, air in the molding die set 1 is purged to produce the decompressed space therein. By closing the molding die set 1, the works W are clamped and semiconductor chips are accommodated in the cavity concave portions 11a as shown in Fig. 3. At that time, no resins flow in the cavity concave portions 11a. Since the works W are resin-molded in the decompressed space, few voids exist in the resins so that quality of the molded products can be improved. In case that a granular resin whose surface area and moisture absorption are greater than those of a tablet resin is used, surplus components can be easily removed by heating the granular resin in the decompressed space, so that forming voids in the molten resin can be effectively prevented. By spraying hot air, whose temperature is higher than that of the molding die set 1, to the first resins 15, the means for promoting meltage of the first resins 15 may be omitted. Further, the decompression mechanism 7 may be omitted according to types of resins, etc.

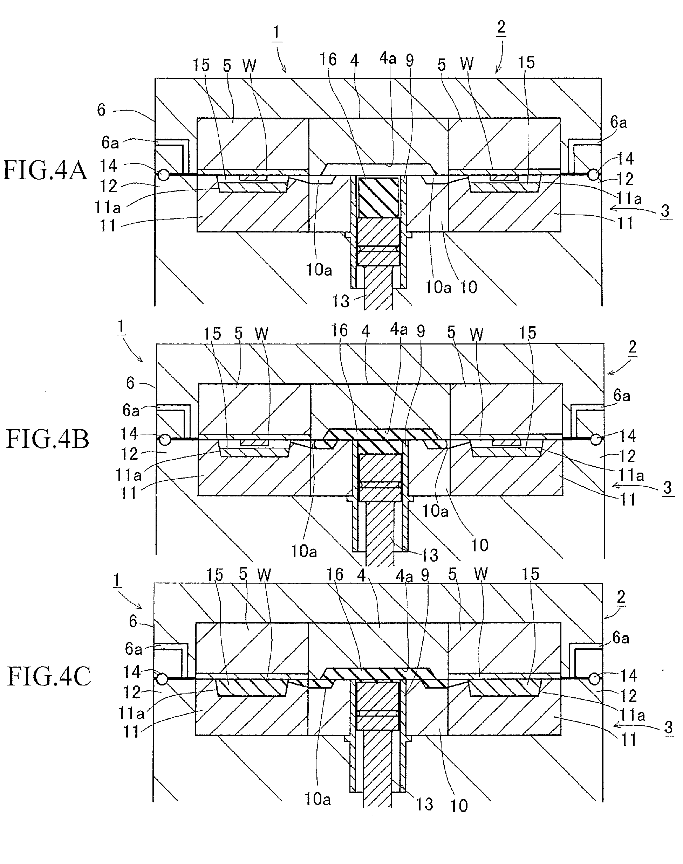

The works W and the first and second resins 15 and 16 are set as shown in Fig. 4A. In this state, the plungers 13 are moved upward, as shown in Fig. 4B, so as to pressurize and send the molten second resins 16 toward the molten first resins 15 in the cavity concave portions 11a. Namely, the transfer molding is performed. Preferably, an enough space is formed between a plastic substrate of each of the works W and the molten first resin 15 even if the semiconductor chips are partially soaked in the molten first resin 15.

By pressurizing and sending the molten second resins 16, the molten second resins 16 sent from the pots 9 are mixed with the molten first resins 15 in the cavity concave portions 11a as shown in Fig. 4C. Then, the mixed resin is thermally cured.

In the present embodiment, the first resin 15 (e.g., granular resin) of an amount slightly less than a required amount for filling the cavity concave portion 11a and fully soaking the semiconductor chips, wires, etc. therein is fed in each of the cavity concave portions 11a. The second resin 16 (e.g., tablet resin) of an amount capable of offsetting the shortage of the first resin 15 in each of the cavity concave portions 11a and filling runners, which communicate the cavity concave portions 11a to each of the pots 9 to apply resin pressure, is fed in each of the pots 9.

In the present embodiment, the amount of the first resin 15 fed in each of the cavity concave portions 11a is a prescribed amount less than the required amount for filling each of the cavity concave portions 11a and fully soaking the semiconductor chips, wires, etc. therein. Namely, it is less than 100 % of the required amount, preferably 60-90 %. The second resin 16 of an amount capable of offsetting the shortage (i.e., the prescribed amount) of the first resins 15 in the cavity concave portions 11a is fed in each of the pots 9.

When the first resins 15 and the second resins 16 are mixed after closing the molding die set 1, air in the runner gates 10a can be easily purged via spaces above the first resins 15 in the cavity concave portions 11a and air vent grooves (not shown) formed in peripheries of the cavity concave portions 11a. Since the second resins 16 are sent to the cavity concave portions 11a via the runner gates 10a, the first resin 15 and the second resin 16 are well mixed in each of the cavity concave portions 11a.

Unlike the compression molding, the amount of the first resin 15 to be fed into each of the cavity concave portions 11a need not be measured precisely. The shortage of the first resin 15 can be offset by sending the second resin 16. Therefore, precise measurement of the first resins 15 is not required, and a production cost of the resin molding apparatus can be reduced.

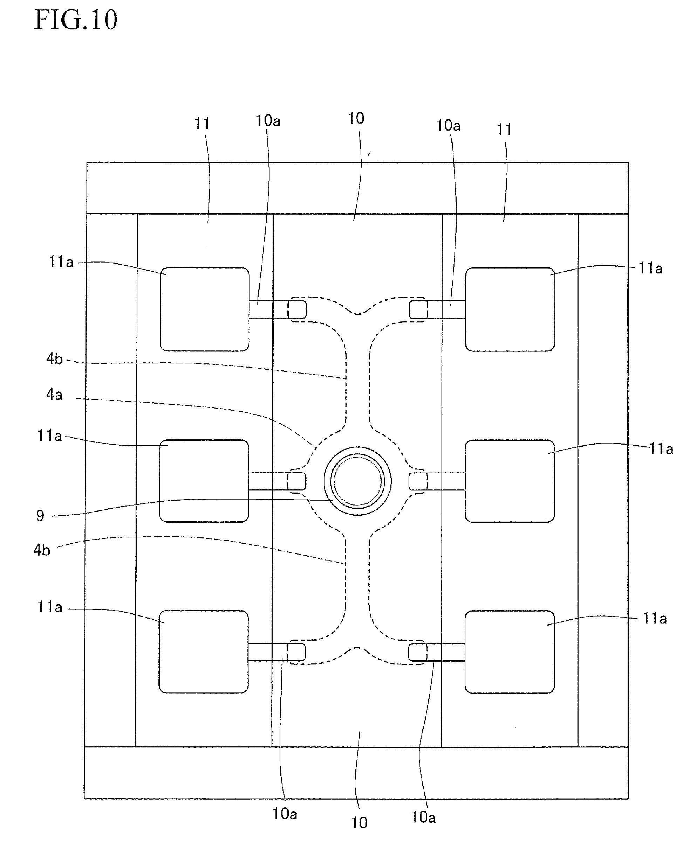

Unlike the conventional resin molding apparatus in which resin is fed to one cavity concave portion from pluralities of pots, the amount of the second resins 16 can be highly reduced, so that number of the pots 9 can be reduced to, for example, one and the structure of the resin molding apparatus of the present embodiment can be simplified. For example, as shown in Fig. 10, the shortages of the first resins 15 in the cavity concave portions 11a are offset by sending the second resin 16 from the one pot 9 via the cull section 4a of the upper die 2, runners 4b of the upper die 2 and the runner gates 10a of the lower die 3. In this case, the pressure equalization unit, which equalizes pressures of the plungers, may be omitted, so that the structure of the transfer mechanism T (see Fig. 6A) can be simplified. Further, if number of the plunger can be reduced to one, the transfer molding can be easily and precisely controlled. An amount of disused resin left in the pot 9 and the runner gates 10a can be reduced.

In case that the amount of the first resin 15 fed in each of the cavity concave portions 11a is markedly less than the required amount for filling each of the cavity concave portions 11a and fully soaking the semiconductor chips, wires, etc. (e.g., 50 % of the required amount or less) therein, the amount of the second resin 16 to be fed into each of the pots 9 may be greater than that of the first resins 15 to be fed into the cavity concave portions 11a so as to offset the shortages of the first resins 15 in the cavity concave portions 11a.

In this case too, the amount of the first resins 15 to be fed into the cavity concave portions 11a need not be measured precisely. The shortages of the first resins 15 can be offset and a prescribed pressure can be applied thereto by pressurizing and sending the second resins 16 to the cavity concave portions 11a. Namely, the shortages of the first resins 15 can be offset by the second resins 16 from the pots 9. The amount of the second resin 16 to be sent is adjusted by adjusting a moving stroke of each of the plungers 13. Therefore, the structure of the means for measuring the resins and the resin feeding action of the feeding handler 17 can be simplified. In comparison with the conventional transfer molding apparatus, the amount of the second resin 16 to be fed can be highly reduced.

Percentage of the amount of the first resin 15 to be fed may be optionally determined as far as the amount of the second resin 16 can be reduced, so the percentage is not limited to the above described percentage. For example, the amount of the first resin 15 to be fed into each of the cavity concave portions 11a may be equal to the required amount for filling the cavity concave portion 11a (i.e., 100 %). In this case, the amounts of the first resins 15 must be measured precisely. If the amount of the first resin 15 fed into each the cavity concave portions 11a is larger than the required amount, leakage of the resin from the cavity concave portions 11a, which occurs when the molding die set 1 is closed, must be prevented. For example, by using granular resin, in which a grain diameter is a prescribed value, e.g., about φ 1.0, and grains have the same shape or weight, as the first resin 15, the amount of the first resin 15 for each of the cavity concave portions 11a can be precisely measured. In case of pressurizing and sending the second resins 16, air vent pins or air vent grooves formed at ends of the runners are required so as to purge air existing in spaces between the pot 9 and the cavity concave portions 11a.

By filling the runner gates with the second resins 16, the resin pressure can be applied to the first resins 15 in the cavity concave portions 11a through the gates. Therefore, movable cavity pieces used in the conventional compression molding apparatus and a release film are not required, so that the production cost of the resin molding apparatus can be reduced. Note that, in this case, the molding die set 1 is closed after producing the decompressed space and fully reducing the inner pressure thereof. Preferably, the resin molding is performed after fully purging air.

When the molded works W which have been thermally cured are taken out from the opened molding die set 1, the molded works W are ejected from the dies 2 and 3 by known ejector pin mechanisms (not shown) provided in the dies 2 and 3 and air suction performed by the decompression mechanism 7 is stopped. Therefore, the molded works W can be taken out from the molding die set 1. The molded works W may be taken out by the feeding handler 17 or other means, e.g., take-out hands.

With the above described structure, the first resin 15 (e.g., granular resin) fed into each of the cavity concave portions 11a can be correctly measured, so the molten first resin 15 hardly flows and the resin pressure of the first resin 15 in each of the cavity concave portions 11a can be maintained at a prescribed value by pressurizing and sending the molten second resin 16 to the cavity concave portion 11a. The first resin 15 and the second resin 16 may be the same resin. Further, different resins, which have different types and characteristics, may be used according to a production cost, a quality of a molded product, etc. For example, the first resin 15, which constitutes the molded product, may be a high quality resin; the second resin 16, which becomes a disused resin, may be an inexpensive resin. Namely, resins which have different characteristics and which respectively correspond to parts of a product, may be previously fed into cavity concave portions so as to produce the product whose parts are molded with the different resins.

Further, as shown in Fig. 6B, the resin molding apparatus may have the second resin feeding section B, which feeds tablet resins, and a resin crushing section F, which crushes tablet resins and feeds the crushed resins as the second resins. The resin crushing section F is provided instead of the first resin feeding section C. The resin crushing section F has a crushing mechanism. For example, a compression crusher, which crushes tablet resins in a closed space by pressing means, a chip crusher or a cutter mill, may be used as the crushing mechanism. In this case, required number of tablet resins, which can fully mold the works W, are prepared, and a part of the tablet resins, which correspond to the amount of the first resins 15 to be fed, are crushed and fed into the hoppers 17a, and the rest tablet resins are held by the tablet holding section 17c. Then, the resins are fed into the molding die set 1.

In the present embodiment, the prescribed resin pressure can be applied by controlling the moving strokes of the plungers 13, so the amounts of the first resins 15 and the second resins 16 need not be measured precisely. Therefore, if the total amount of the first resins 15 and the second resins 16 (the total number of the tablet resins) is previously determined, the predetermined amount of the inexpensive tablet resins are crushed, without measurement, and fed to the cavity concave portions 11a, as the first resins 15, by the resin crushing section F. The crushed resins are easily molten in the cavity concave portions 11a, and the first resins 15 and the second resins 16 are the same resins stored in the same environment (e.g., thermal history, moisture absorption), so that the resins can be easily handled and qualities of molded products can be stabilized. By using the inexpensive tablet resins only, a production cost of the molded products can be reduced.

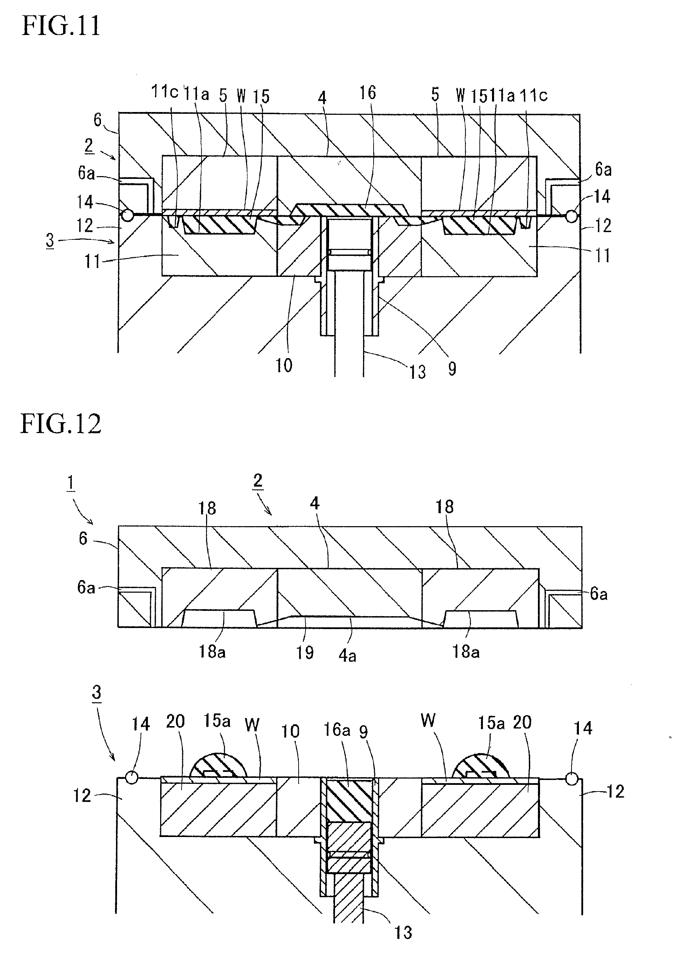

Further, as shown in Fig. 11, overflow cavities 11c may be respectively formed around the cavity concave portions 11a of the cavity inserts 11. When the transfer mechanism actuates the plungers 13 to mix the second resin 16 with the first resins 15, the first resins 15 are introduced into the overflow cavities 11c.

By using the overflow cavities 11c, when the pressurized second resins 16 are mixed with the first resins 15 in the cavity concave portions 11a, forward end parts of the first resins 15, which have been firstly fed into the cavity concave portions 11a and deteriorated, are introduced into the overflow cavities 11c, so that qualities of the molded products can be improved.

### (Embodiment 2)

Next, Embodiment 2 of the present invention will be explained with reference to Figs. 12-13B. Note that, the structural elements described in Embodiment 1 are assigned the same symbols and explanation will be omitted. Unique features of Embodiment 2 will be mainly explained.

Each of the works W is constituted by a plastic substrate and semiconductor chips, etc., which are mounted on the plastic substrate. As shown in Fig. 12, the upper die 2 includes cavity inserts 18, in each of which cavity concave portions 18a are formed. The cull sections 4a and runner gates 19, which are communicated to the cull sections 4a, are formed in the cull insert 4.

In the lower die 3, the works W are mounted on lower die inserts 20. Second resins 16a (e.g., liquid resin) are fed into the pots 9, and a first resin 15a (e.g., liquid resin) of an amount for molding the work W is fed to each of the works W by a syringe of a feeding handler (not shown).

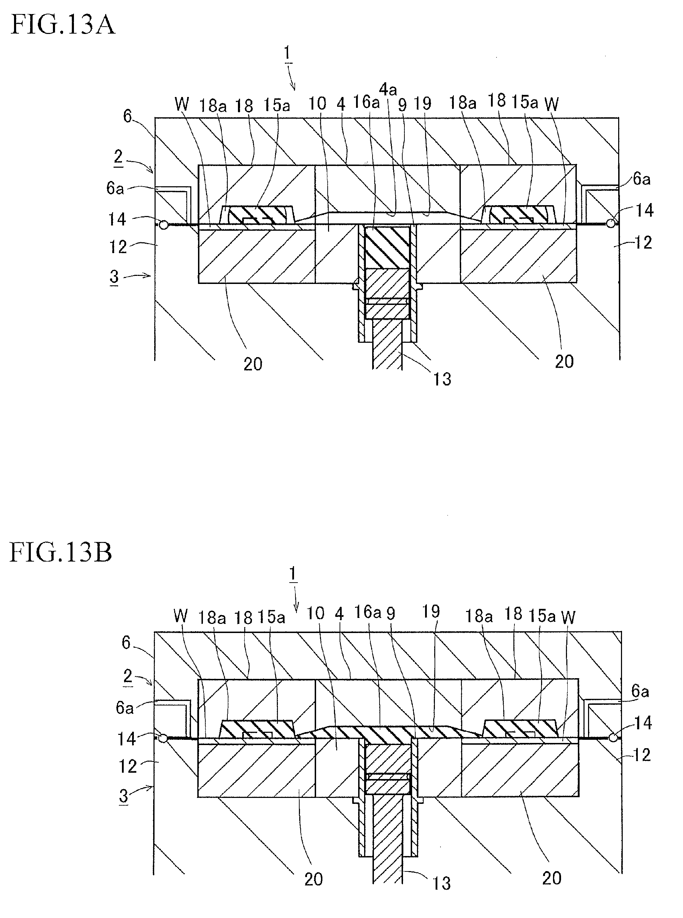

In Fig. 13A, the second resins 16a (e.g., liquid resin) are fed into the pots 9, and the first resins 15a (e.g., liquid resin) are respectively fed to the works W on the lower die inserts 20. Then, the lower die 3 is moved upward, with actuating the decompression mechanism 7 connected to the upper die 2, so as to close the molding die set 1. When the upper mold chase 6 contacts the seal members 14 of the lower mold chase 12, air in the molding die set 1 is purged to produce the decompressed space. When the closing action is completed, the first resins 15a (e.g., liquid resin) are pressed and extended in cavity concave portions 18a of the upper die 2, so that the cavity concave portions 18a are filled with the first resins 15a. Flow of each of the first resins 15a is limited in a limited are of the cavity concave portion 18a.

Next, as shown in Fig. 13B, the transfer molding is performed. Namely, the second resins 16a (e.g., liquid resin), which have been molten in the pots 9, are pressurized and sent, by moving the plungers 13 upward, toward the first resins 15a, which have been molten in the cavity concave portions 18a, via the cull sections 4a and the runner gates 19. Note that, viscosities of the liquid resins 15a and 16a are lowered by heat from heaters of the molding die set 1. Note that, in the present specification, the resins whose viscosities are lowered are also called "molten resins".

Each of the first resins 15a molten in the cavity concave portion 18a and each of the second resins 16a molten in the pot 9 are mixed, and the resin pressure of the mixed resin is maintained at a prescribed value so as to thermally cure the mixed resin.

In the present embodiment, the cavity concave portions 18a are formed in the upper die 2, and the liquid resins are fed to the works W as the first resins 15a. Therefore, the amount of the second resins 16a can be reduced, so that the effects of Embodiment 1 can be obtained as well. Further, granular resins may be fed to the works W as the first resins 15a.

### (Embodiment 3)

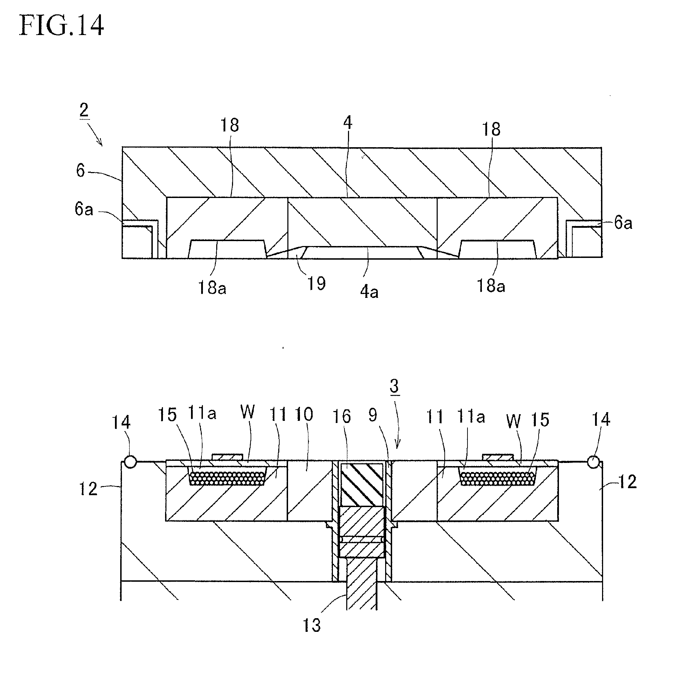

Next, Embodiment 3 of the present invention will be explained with reference to Fig. 14. Note that, the structural elements described in the foregoing embodiments are assigned the same symbols and explanation will be omitted. Unique features of Embodiment 3 will be mainly explained.

Each of the works W is constituted by a substrate and semiconductor chips, which are mounted on the substrate.

The upper die 2 includes the upper cavity inserts 18, in each of which upper cavity concave portions 18a are formed, and the lower die 3 includes the lower cavity inserts 11, in each of which the lower cavity concave portions 11a are formed.

In the present embodiment, the first resins 15 (e.g., granular resin) are fed into the lower cavity concave portions 11a. The amount of the first resin 15 fed in each of the lower cavity concave portions 11a is less than a capacity of each of cavities. Each of the cavities is constituted by the lower cavity concave portion 11a and the upper cavity concave portion 18a. Thus, the second resin 16 (e.g., tablet resin) of an amount capable of offsetting the shortages of the first resins 15 are fed into each of the pots 9. The cavities cannot be filled with the first resins 15a by merely closing the molding die set, so the second resins 16a, which have been molten in the pots 9, are sent to the cavities by the transfer molding manner. The second resins 16 fill the cavities (the cavity concave portions 11a and 18a) through spaces between leads of the semiconductor chips. Note that, in case of using a plastic substrate, through-holes communicating the both side faces may be formed.

In the present embodiment too, the amount of the first resin 15 (e.g., granular resin) to be fed into each of the lower cavity concave portions 11a need not be measured precisely. The shortage of the first resin 15 in each of the cavities can be offset by sending the molten second resin 16 (e.g., tablet resin) from the pot 9. Therefore, feeding the resins can be easily performed by the feeding handler 17 (see Fig. 7).

Note that, the lower cavity concave portions 11a may be filled with the first resins 15, and the upper cavity concave portions 18a may be filled with the second resins 16. In this case, characteristics of the resins may be willfully changed.

### (Embodiment 4)

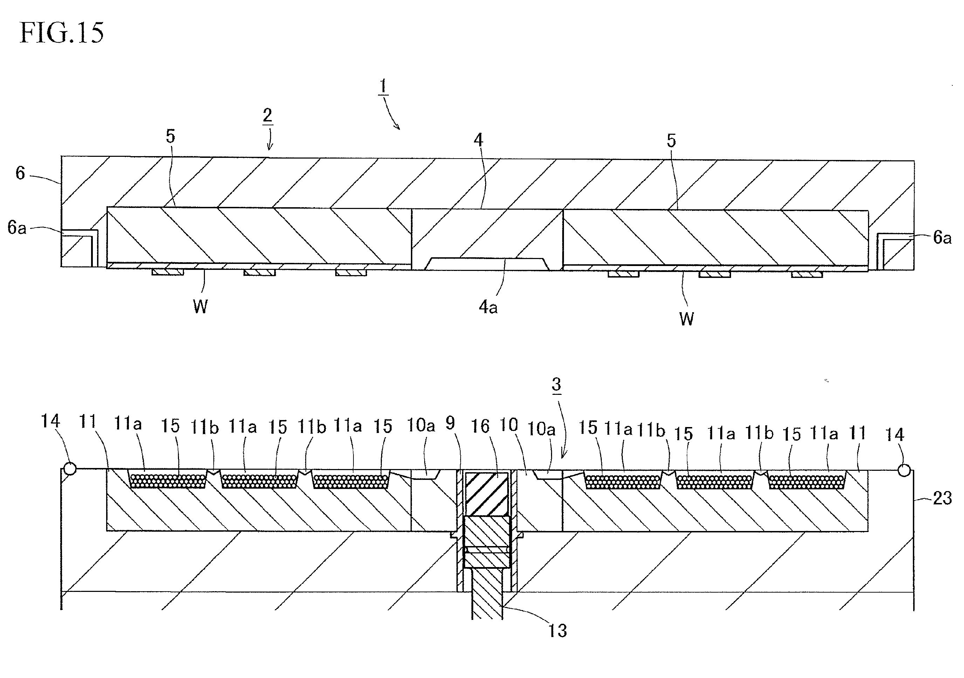

Next, Embodiment 4 of the present invention will be explained with reference to Fig. 15. Note that, the structural elements described in the foregoing embodiments are assigned the same symbols and explanation will be omitted. Unique features of Embodiment 4 will be mainly explained.

Each of the works W is constituted by a substrate and a matrix of semiconductor chips, which are mounted on the substrate.

The works W are sucked and held on the upper die inserts 5. The cavity concave portions 11a are formed in the cavity inserts 11 of the lower die 3 and arranged like a matrix so as to correspond to the matrix of semiconductor chips. The pot insert 10 and the cavity inserts 11 are detachably attached to a lower mold chase 23. The amount of the first resin 15 (e.g., granular resin) fed in each of the cavity concave portions 11a is slightly less than the required amount for filling each of the cavity concave portions 11a and fully soaking the semiconductor chip, wires, etc. therein, and the second resins 16 (e.g., tablet resin) are fed into the pots 9 as well as Embodiment 1. The cavity concave portions 11a are communicated to the cavity concave portion 11a communicated to the runner gate 10a by through gates 11b, each of which communicates the adjacent cavity concave portions 11a to each other. With this structure, the molten second resins 16, which have been molten in the pots 9, are pressurized and sent to the cavity concave portions 11a, so as to supplement the molten first resins 15 (e.g., granular resin) with applying the prescribed resin pressure. In the present embodiment, the tablets resins are used as the second resins 16, but the granular resins may be used as the second resins 16 as well as the first resins 15. In this case, the same type of resin is used as the first and second resins 15 and 16, so it is easy to manage the resins.

Preferably, the first resins 15 (e.g., granular resin) have a prescribed grain diameter, e.g., about φ 1.0, and grains of the first resins 15 are formed into spherical shapes. A feeding handler is capable of individually feeding the first resins 15 into the cavity concave portions 11a. Therefore, number of the hoppers 17a, each of which has the shutter 17b (see Fig. 7), is equal to that of the cavity concave portions 11a. With this structure, the constant amount of the first resin 15 can be fed into each of the cavity concave portions 11a, and measurement of the first resins 15 can be easily performed. Even if the number of the cavity concave portions 11a is increased, it does not take a long time to feed the first resins 15. Further, unlike ordinary granular resins, the first resins 15 do not include fine powders, so that forming resin flashes between the dies 2 and 3 can be prevented.

The semiconductor chips of the works W are respectively fed into the cavity concave portions 11a and soaked into the molten first resins 15 therein in a state where the decompressed space is produced in the molding die set 1. The molten second resins 16, which have been molten in the pots 9, are pressurized and sent to the cavity concave portions 11a via the runner gates 10a and the through gates 11b, so that the molten first resins 15 and the molten second resins 16 are mixed and thermally cured in the cavity concave portions 11a with applying the prescribed resin pressure.

Note that, as shown in Fig. 12, the molding die set 1 may have the upper die 2 including the upper cavity inserts 18, in which the upper cavity concave portions 18a are formed and arranged like a matrix, and the lower die 3 including the lower die inserts 20, on which the works W are mounted.

In the present embodiment, as described above, even pluralities of the cavity concave portions 11a are mutually communicated to each other by the through gates 11b, the amount of the second resins 16 to be fed can be reduced by feeding the first resins 15 into the cavity concave portions 11a. Therefore, the effects of the foregoing embodiments can be obtained in the present embodiment, too. Further, an amount of the resin passing through each of the through gates 11b can be reduced, so that abrasion of the through gates 11b can be restrained.

### (Embodiment 5)

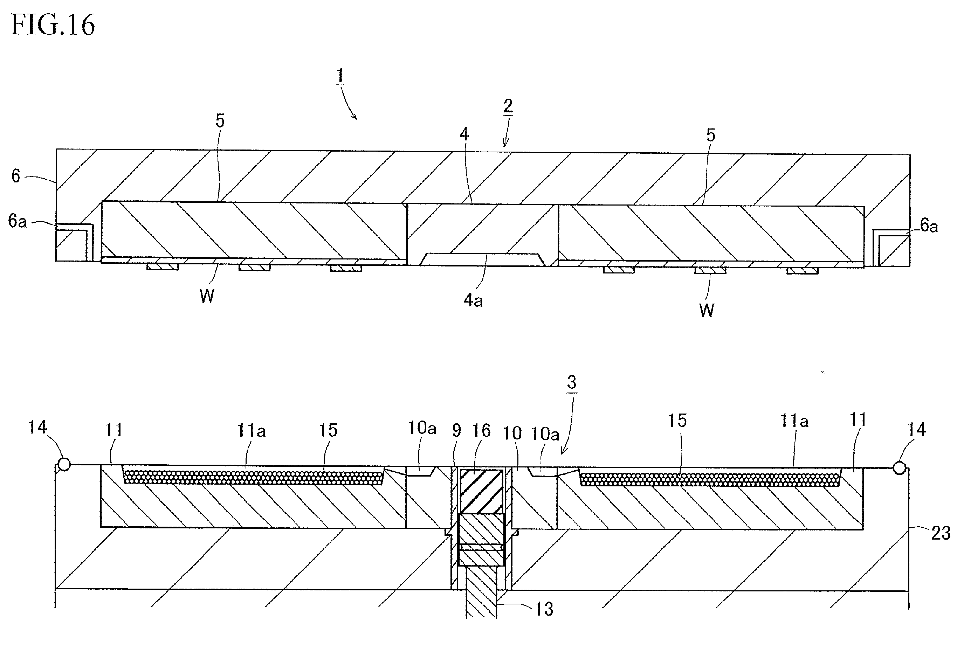

Next, Embodiment 5 of the present invention will be explained with reference to Fig. 16. Note that, the structural elements described in the foregoing embodiments are assigned the same symbols and explanation will be omitted. Unique features of Embodiment 5 will be mainly explained.

Each of the works W is constituted by a substrate and a matrix of semiconductor chips, which are mounted on the substrate, as well as Embodiment 4.

The works W are sucked and held on the upper die inserts 5. A matrix of the semiconductor chips can be simultaneously resin-molded in each of the cavity concave portions 11a of the cavity inserts 11 of the lower die 3. The pot insert 10 and the cavity inserts 11 are detachably attached to a lower mold chase 23. The amount of the first resin 15 (e.g., granular resin) fed in each of the cavity concave portions 11a is slightly less than the required amount for filling each of the cavity concave portions 11a and fully soaking the semiconductor chip, wires, etc. therein, and the second resins 16 (e.g., tablet resin) are fed into the pots 9 as well as Embodiment 1.

The semiconductor chips of the works W are fed into the cavity concave portions 11a and soaked into the molten first resins 15 therein in a state where the decompressed space is produced in the molding die set 1. The molten second resins 16, which have been molten in the pots 9, are pressurized and sent to the cavity concave portions 11a, so that the molten first resins 15 and the molten second resins 16 are mixed and thermally cured in the cavity concave portions 11a with applying the prescribed resin pressure.

Note that, as shown in Fig. 12, the molding die set 1 may have: the upper die 2 which includes the upper cavity inserts 18 having the upper cavity concave portions 18a, each of which is capable of resin-molding pluralities of the semiconductor chips; and the lower die 3 which includes the lower die inserts 20, on which the works W are mounted.

### (Embodiment 6)

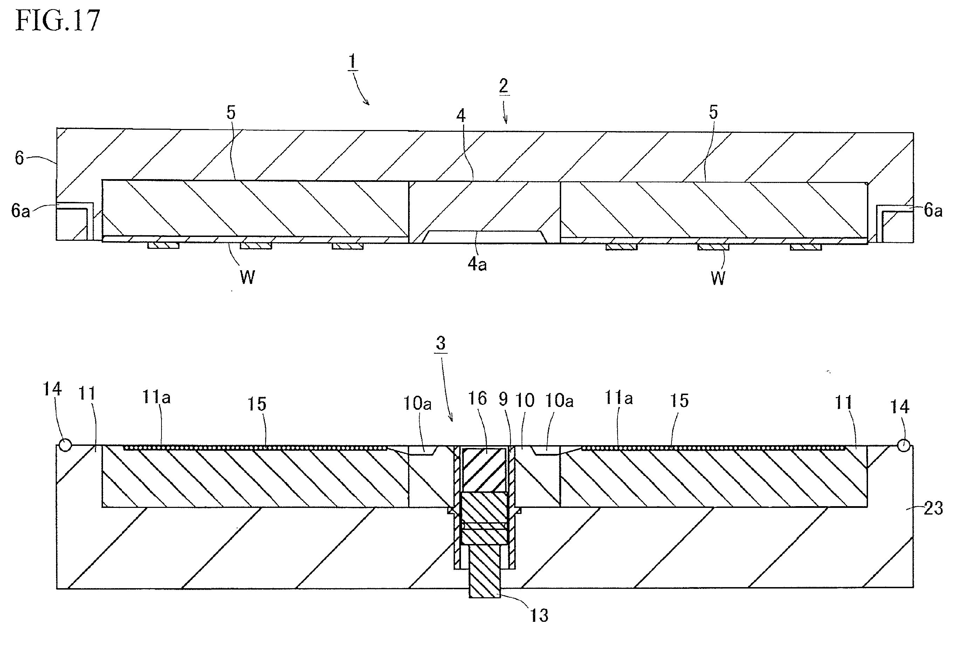

Next, Embodiment 6 of the present invention will be explained with reference to Fig. 17. Note that, the structural elements described in the foregoing embodiments are assigned the same symbols and explanation will be omitted. Unique features of Embodiment 6 will be mainly explained.

Each of the works W is constituted by a substrate and a matrix of semiconductor chips, which are mounted on the substrate, as well as Embodiment 4. The works W are thin and large works, in which a thickness of resin-molded packages is, for example, 0.2 mm. For example, a large substrate on which many laminated chips are mounted (e.g., POP), an E-WLP (Embedded Wafer Level Package), etc. may be used as the work W. In the molding die set 1, the cavity concave portions 11a, each of which is capable of simultaneously resin-molding semiconductor chips, are made shallow, but other structural elements are similar to those of Embodiment 5. The amount of the first resin 15 (e.g., granular resin) fed in each of the cavity concave portions 11a is slightly less than the required amount for filling each of the cavity concave portions 11a and fully soaking the semiconductor chip, wires, etc. therein, and the second resins 16 (e.g., tablet resin) are fed into the pots 9 as well as Embodiment 1. In the present embodiment, packages to be molded is thin, so the first resins 15 (e.g., granular resin) are immediately molten when they are fed into the cavity concave portions 11a. Therefore, the molten first resins 15 can sufficiently fill the cavity concave portions 11a without flowing.

For example, in case of molding the works including laminated chips, e.g., POP, a thickness of each of packages is thin, but the chips are laminated and made thick, so a thickness of a resin layer covering the laminated chips is very thin. However, in the present embodiment, the first resins 15 (e.g., granular resin) are previously fed into the cavity concave portions 11a, so that the first resins 15 need not be fed into very small spaces above the laminated chips. Therefore, even in case of resin-molding high performance packages, the resins can be securely fed onto the chips, and forming voids or insufficiently filling the cavity concave portions 11a can be prevented, so that qualities of the molded products can be improved.

Note that, as shown in Fig. 12, the molding die set 1 may have: the upper die 2 which includes the upper cavity inserts 18 having the upper cavity concave portions 18a, each of which is capable of resin-molding pluralities of the semiconductor chips; and the lower die 3 which includes the lower die inserts 20, on which the works W are mounted.

### (Embodiment 7)

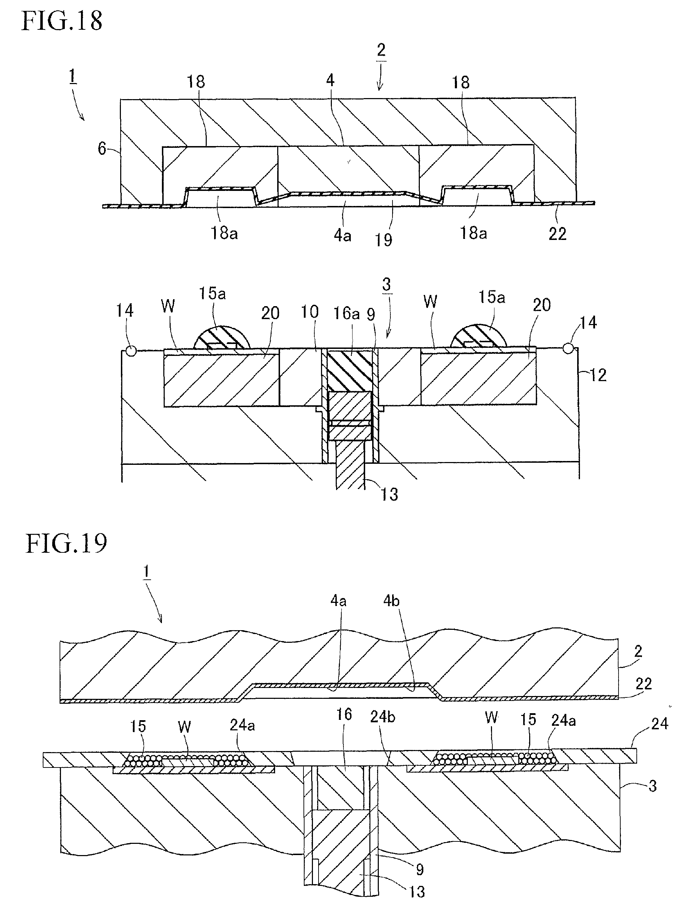

Next, Embodiment 7 of the present invention will be explained with reference to Fig. 18. Note that, the structural elements described in the foregoing embodiments are assigned the same symbols and explanation will be omitted. Unique features of Embodiment 7 will be mainly explained.

Each of the works W is constituted by a substrate and semiconductor chips, which are mounted on the substrate, as well as Embodiment 2. The structure of the molding die set 1 is the same as that of the molding die set shown in Fig. 8. In the upper die 2, the upper cavity concave portions 18a are formed in the upper cavity inserts 18. In the cull insert 4, the runner gates 19 are communicated to the cull sections 4a. A release film 22 are sucked and held on a clamping face of the upper die 2, which includes runners, e.g., the cull sections 4a, the runner gates 19, the upper cavity concave portions 18a.

In the lower die 3, the works W are mounted on lower die inserts 20. The second resins 16a (e.g., liquid resin) are fed into the pots 9, and the first resin 15a (e.g., liquid resin) of an amount slightly less than the required amount for soaking the semiconductor chips, wires, etc. is fed to each of the works W by a syringe of a feeding handler (not shown).

The second resins 16a (e.g., liquid resin) are fed into the pots 9, and the first resins 15a (e.g., liquid resin) are respectively fed to the works W on the lower die inserts 20. Then, the lower die 3 is moved upward, with actuating the decompression mechanism 7 connected to the upper die 2, so as to close the molding die set 1.

In the present embodiment, the clamping face of the upper die 2 is covered with the release film 22, so that maintenance of the molding die set 1 can be easily performed, and abrasion of the dies 2 and 3 can be prevented. The release film 22 covers the upper cavity concave portions 18a. Further, another release film may be provided under the works W and in the pots 9. The release films may be provided to both of the upper and lower dies 2 and 3.

### (Embodiment 8)

Next, Embodiment 8 of the present invention will be explained with reference to Fig. 19. Note that, the structural elements described in the foregoing embodiments are assigned the same symbols and explanation will be omitted. Unique features of Embodiment 8 will be mainly explained.

Each of the works W is constituted by a substrate and semiconductor chips, which are mounted on the substrate, as well as Embodiment 1.

The works W and a cavity plate 24, in which cavity holes 24a for defining an external shape and a thickness of packages of molded products are formed and which can be repeatedly conveyed into and out from the molding die set 1, are set at prescribed positions in the molding die set 1. The cavity plate 24, in which the works W are respectively located in the cavity holes 24a, is clamped between the dies 2 and 3 by closing the molding die set 1. In this state, the works W are resin-molded. The cavity plate 24 is a metal plate and preheated at a position outside of the molding die set 1. The preheated cavity plate 24 is conveyed into the molding die set 1 together with the works W. Pluralities of the cavity holes 24a and pluralities of pot holes 24b are formed in the cavity plate 24. The release film 22 is sucked and held on the clamping face of the upper die 2, which includes the cull sections 4a and runners 4b. The release film 22 covers the clamping face of the upper die 2. Further, another release film may be provided under the works W and in the pots 9. The release films may be provided to both of the upper and lower dies 2 and 3.

The cavity plate 24, on which the substrate is stacked, is set on the lower die 3. The first resin 15 (e.g., granular resin) of the prescribed amount is fed into each of the cavity holes 24a, and the second resins 16 (e.g., tablet resin) are fed into the pots 9 via the pot holes 24b. The molding die set 1 is closed to clamp the works W and the cavity plate 24. Then, the plungers 13 are moved upward, by actuating the transfer mechanism, so as to pressurize and send the second resins 16 to the cavity holes 24a via the pot holes 24b, the cull sections 4a and the runners 4b. The first resins 15 and the second resins 16 are mixed in the cavity holes 24a, and the mixed resin is thermally cured therein.

In the present embodiment, even in case of forming the packages on the upper sides of the works W, spilling the granular resins can be restrained, so that forming resin flashes, which are formed by clamping spilled resins, can be securely prevented. Even in case of feeding liquid resins of low viscosity to the upper sides of the works, extending the liquid resins beyond the cavity holes 24a can be securely prevented. Since the cavity plate 24 can be easily exchanged, size and number of the cavity holes can be easily changed.

Note that, the molded products can be taken out from the molding die set 1 together with the cavity plate 24, and the molded products can be separated from the cavity plate 24 and taken out.

### (Embodiment 9)

Next, Embodiment 9 of the present invention will be explained with reference to Fig. 20. Note that, the structural elements described in the foregoing embodiments are assigned the same symbols and explanation will be omitted. Unique features of Embodiment 9 will be mainly explained.

Each of the works W is constituted by a substrate and semiconductor chips, which are mounted on the substrate, as well as Embodiment 1.

In the present embodiment too, the cavity plate 24 composed of a metal is used as well as Embodiment 8. Cavity concave portions 24c are formed in an upper face of the cavity plate 24. Vertical gates 24d, each of which is communicated to each of the cavity concave portions 24c, are vertically formed from a lower face of the cavity plate 24, and plate cull sections 24e are formed in the lower face thereof.

The works W are sucked and held on the clamping face of the upper die 2 of the opened molding die set 1. The second resins 16 (e.g., tablet resin) are fed into the pots 9 of the lower die 3. The cavity plate 24 is set on the clamping face of the lower die 3 in a state where the plate cull sections 24e correspond to the pots 9. The first resin 15 (e.g., granular resin) of an amount slightly less than the required amount for soaking the semiconductor chips, wires, etc. is fed to each of the cavity concave portions 24c by a feeding handler (not shown).

The molding die set 1 is closed to clamp the works W and the cavity plate 24. Then, the plungers 13 are moved upward, by actuating the transfer mechanism T (see Fig. 6B), so as to pressurized and send the second resins 16 to the cavity concave portions 24c via the plate cull sections 24e, the runner gates 10a and the vertical gates 24d. The first resins 15 and the second resins 16 are mixed in the cavity concave portions 24c.

The resin pressure the second resins 16 is applied to the first resins 15 in the cavity concave portions 24c via the vertical gates 24d. In this state, the mixed resins are thermally cured.

The molded products can be taken out from the molding die set 1 together with the cavity plate 24, and the molded products can be separated from the cavity plate 24 and taken out.

The molding die set may be constituted by the upper die 2, the lower die 3 and an intermediate die (not shown) including the cavity holes 24a as a modified example of the present embodiment. In this case, the intermediate die is vertically moved between the upper die 2 and the lower die 3 so as to feed the first resins 15, the second resins 16 and the works W. After completing the actions of feeding the first resins 15, the second resins 16 and the works W, the above described molding steps are performed.

In case of feeding the second resins 16 through the vertical gates 24d, the above described resin molding method can be applied. In this case, the first resin 15 of a prescribed amount is fed to each of the cavity concave portions 24c, and then the second resins 16 are fed into the cavity concave portions 24c via the vertical gates 24d, so that the prescribed resin pressure can be applied in the cavity concave portions 24c. Therefore, the effects of the former embodiments can be obtained in the present embodiment, too. The resin molding method of the present invention can be applied to various types of molding die sets, each of which includes the pots and the cavity concave portions, and the suitable effects of the present invention can be obtained.

In the above described resin molding apparatuses and methods, the molten first resins 15 and the molten second resins 16 are mixed, so that the amount of resin flow can be reduced, loads applied to the works W can be reduced and abrasion of the molding dies, especially gates, can be restrained. The resin pressure in the cavity concave portions can be maintained, at the prescribed pressure, by the transfer mechanism T (see Fig. 6B), so that the cavity concave portions can be perfectly filled with the resins and qualities of the molded products, especially thin products, can be improved. By previously feeding the first resin 15 into each of the cavity concave portions 11a, no influence is caused by the capacity of the pots 9 even if the required amount of the first resin 15 for each of the cavity concave portions 11a is increased. Therefore, even if the required amount of the resins for molding the works W is increased, number of the cavity concave portions can be increased and number of the products molded at a time can be increased. Further, the structure of the transfer mechanism T can be simplified by reducing number of the pots.

By employing the feeding handler 17, the works W and the resins can be efficiently fed to the molding die set 1 by one reciprocating motion.

In the above described embodiments, the conventional units, e.g., molding die set, press unit, can be used. Therefore, the present invention can be realized by adding simple and inexpensive units to the conventional units. Therefore, the production cost of the resin molding apparatus can be reduced.

In the above described embodiments, granular resin or liquid resin, which can be easily measured, is used as the first resin 15. The first resin may be powder resin or tablet resin. The tablet resin may be ordinary mini-tablet resin, or the tablet resin may be formed into, for example, a plate-like shape or a columnar shape, whose size is smaller than that of the cavity concave portion. Tablet resin is used as the second resin 16, but the second resin may be granular resin, liquid resin or powder resin.

In the present invention, a wafer for WLP (Wafer Level Package) or a carrier plate for E-WLP (Embedded Wafer Level Package), on which semiconductor chips are bonded, etc. may be resin-molded as the work W. A lead frame, a QFN or a ceramic substrate, on which LED chips are mounted, may be resin-molded as the work W. A plastic or a ceramic substrate, on which flip-chip type semiconductor chips are mounted, may be used as the work W, and the work may be over-molded and underfilled. Semiconductor chips need not be mounted on the work W. For example, a substrate of a stiffener, which is used for fixing a reflector of an LED or a heat sink, or a lead frame may be resin-molded as the work W. As described above, many kinds of parts and members can be resin-molded by the resin molding apparatus and method of the present invention as the works, and the above described effects can be obtained.

In the above described embodiments, the molding die set 1 is constituted by the upper fixed die 2 and the lower movable die 3. The present invention is not limited to the above described embodiments. For example, the molding die set 1 may be constituted by the upper movable die 2 and the lower fixed die 3, or the both dies 2 and 3 may be movable dies.

Arrangement of the works W may be map-like arrangement or matrix-like arrangement. In case of molding thin packages by a compression molding apparatus or a TCM apparatus, a release film is required. However, in the resin molding apparatus of each of the embodiments, the molding die set has no movable parts so that the release film is not required. Therefore, the shapes of the cavity concave portions can be perfectly copied as the shapes of packages. Namely, the packages can be correctly formed. Since the molding die set has no movable parts, the cavity concave portions may be integrated cavities so that the structure of the molding die set or the resin molding apparatus can be simplified.

In case of using a large cavity concave portions, each of which is filled with a large amount of the resin, the first resin is fed into the cavity concave portion and the amount of the second resin can be reduced, so that number of the pots can be reduced to, for example, one. In case of the single pot, the pressure equalization unit of the plungers can be omitted, so that the structure of the transfer mechanism can be simplified. The plunger can be controlled precisely and easily.

Even if a capacity of the cavity concave portion is increased, the required amount of the resin can be fed by merely increasing the amount of the first resin fed in the cavity concave portion. Therefore, the versatility of the resin molding apparatus can be expanded.

## Claims

1. A resin molding method,
comprising the steps of:
feeding a first resin (15, 15a) to a cavity concave portion (11a, 1 8a) of a molding die set (1), which is opened, and a second resin (16, 16a) to a pot (9) thereof;
feeding a work (W) to a prescribed position of the molding die set (1), which corresponds to the cavity concave portion (11a, 18a);
closing the molding die set (1) so as to clamp the work (W); and
pressurizing and sending the molten second resin (16, 16a), which has been molten in the pot (9), to the cavity concave portion (11a, 18a), by a manner of transfer-molding, so as to mix the molten first resin (15, 15a), which has been molten in the cavity concave portion (11a, 18a), and the molten second resin (16, 16a) and cure the mixed resin with maintaining a prescribed resin pressure.

2. The method according to claim 1,
wherein the first resin (15, 15a) is fed to the cavity concave portion (11a, 18a) of the molding die set (1) and the second resin (16, 16a) is fed to the pot (9) thereof, the work (W) is fed to the prescribed position of the molding die set (1), which corresponds to the cavity concave portion (11a, 18a),
the molten second resin (16, 16a), which has been molten in the pot (9), is pressurized and sent, by actuating a plunger (13), toward the molten first resin (15, 15a), which has been molten in the cavity concave portion (11a, 18a),
the molten first resin (15, 15a) is mixed with the molten second resin (16, 16a), which has been pressurized and sent from the pot (9), and
the mixed resin (15, 15a, 16, 16a) is thermally cured with maintaining a prescribed resin pressure.

3. The method according to claim 1 or 2,
wherein the first resin (15, 15a) and the second resin (16, 16a) are powder resin, granular resin, liquid resin, tablet resin or combination thereof.

4. The method according to any one of claims 1-3,
wherein an inner space of the molding die set (1) is shielded from outside and a decompressed space is produced in the inner space before completing a clamping action of the molding die set (1).

5. The method according to any one of claims 1-4,
wherein an amount of the first resin (15, 15a) to be fed is a prescribed amount less than that for filling the cavity concave portion (11a, 18a), and
an amount of the second resin (16, 16a) to be fed is equal to the prescribed amount so as to offset the shortage of the first resin (15, 15a).

6. The method according to any one of claims 1-5,
wherein the first resin (15, 15a) is introduced into an overflow cavity (11c) when the molten first resin (15, 15a) and
the molten second resin (16, 16a) are mixed.

7. The method according to any one of claims 1-6,
wherein a release film (22) is sucked and held on a clamping face of a molding die (2, 3), which includes the cavity concave portion (11a, 18a).

8. The method according to any one of claims 1-7
wherein the first resin (15, 15a) is produced by crushing tablet resin, which is used as the second resin (16, 16a).

9. A resin molding apparatus,
comprising:
a molding die set (1 having a cavity concave portion (11a, 18a) formed in a clamping face; means for feeding a first resin (15, 15a) to the cavity concave portion (11a, 18a); means for feeding a second resin (16, 16a) to a pot (9); means for feeding a work (W) to a prescribed position corresponding to the cavity concave portion (11a, 18a); and
a transfer mechanism (T) for closing the molding die set (1) so as to clamp the work (W), the transfer mechanism actuating a plunger (13) so as to pressurize and send the molten second resin (16, 16a) to the cavity concave portion (11a, 18a) and mix the molten second resin (16, 16a) with the molten first resin (15, 15a),
whereby, in operation, the mixed resin (15, 15a, 16, 16a) is thermally cured in the cavity concave portion (11a, 18a) while a prescribed resin pressure is maintained.

10. The resin molding apparatus according to claim 9,
further comprising a decompressing mechanism (7) for shielding an inner space of the molding die set (1) from outside and producing a decompressed space in the inner space by purging air when the molding die set (1) is closed.

11. The resin molding apparatus according to claim 9 or 10,
wherein an overflow cavity (11c), which is communicated to the cavity concave portion (11a, 18a), is formed in the clamping face of the molding die (2, 3), so that, in operation,
the first resin (15, 15a) is introduced into the overflow cavity (11c) when the molten first resin (15, 15a) and the molten second resin (16, 16a) are mixed.

12. The resin molding apparatus according to any one of claims 9-11,
further comprising a resin crushing section (F) for crushing a resin tablet so as to use the crushed resin as the first resin (15, 15a) and the second resin (16, 16a).

13. The resin molding apparatus according to any one of claims 9-12, including means whereby
a release film (22) is sucked and held on the clamping face of the molding die (2, 3), in which the cavity concave portion (11a, 18a) is formed.

14. A feeding handler (17) operable to be moved into and away from the opened molding die set (1) of any one of claims 9-13 so as to feed a same type of resin or different types of resins to the pot (9) and the cavity concave portion (11a, 18a).

15. The feeding handler (17) according to claim 14,
wherein the feeding handler (17) is operable to feed not only the first resin (15, 15a) and the second resin (16, 16a) but also a work (W) to a prescribed position corresponding to the cavity concave portion (11a, 18a).

16. The resin molding apparatus according to any one of claims 9 to 13 including a feeding handler according to claim 14 or claim 15.
